# EUROPÄISCHE PATENTSCHRIFT

(11) **EP 0 836 749 B1**
(45) Veröffentlichungstag und Bekanntmachung des Hinweises auf die Patenterteilung: **30.08.2000**
(21) Anmeldenummer: 96917345.9
(22) Anmeldetag: 13.06.1996
(51) Int. Cl.: H01L 29/10, H01L 29/32, H01L 29/744

(54) **THYRISTOR MIT SCHICHT REDUZIERTER LADUNGSTRÄGERLEBENSDAUER**
THYRISTOR WITH A LAYER OF CHARGE CARRIERS HAVING A REDUCED LIFETIME
THYRISTOR POURVU D'UNE COUCHE DE PORTEURS DE CHARGE A DUREE DE VIE REDUITE

(30) Priorität: 03.07.1995 DE 19524161
(43) Veröffentlichungstag der Anmeldung: 22.04.1998
(73) Patentinhaber: SIEMENS AKTIENGESELLSCHAFT, 80333 München (DE)
(72) Erfinder: SCHULZE, Hans-Joachim, D-85521 Ottobrunn (DE)
(86) Internationale Anmeldenummer: DE9601052
(87) Internationale Veröffentlichungsnummer: WO9702603

(56) Entgegenhaltungen:
- EP-A- 0 297 325
- EP-A- 0 343 369
- EP-A- 0 651 446
- FR-A- 2 344 962
- PATENT ABSTRACTS OF JAPAN vol. 11, no. 275 (E-537), 5.September 1987 & JP,A,62 076556 (TOYOTA CENTRAL RES & DEV LAB INC), 8.April 1987,

## Beschreibung

Bei Thyristoren bzw. GTO's (Gate-Turn-Off-Thyristoren) bedeutet eine Verbesserung des Ein- und Ausschaltverhaltens vor allem eine Verringerung des Zündstroms und der Abschaltverlustleistung sowie eine Erhöhung des maximal abschaltbaren Stromes.

Aus der internationalen Anmeldung mit der Veröffentlichungsnummer WO 92/17907 ist ein Verfahren zur Einstellung der Kippspannung eines Thyristors bekannt, bei dem die Anodenseite eines Thyristors ganzflächig mit Protonen oder Heliumkernen bestrahlt wird, wobei durch Zwischenschaltung einer Blende Zonen mit verminderter Ladungsträgerlebensdauer gebildet werden, die einen unterschiedlichen Abstand zum anodenseitigen pn-Übergang des Thyristors aufweisen.

Die der Erfindung zugrundeliegende Aufgabe besteht darin, die Zündströme, die Einrastströme und die Abschaltverlustleistung gegenüber bekannten Thyristoren zu reduzieren sowie die maximal abschaltbaren Ströme gegenüber bekannten Thyristoren zu erhöhen. Diese Aufgabe wird erfindungsgemäß durch die Merkmale des Patentanspruchs 1 gelöst.

Eine weitere der Erfindung zugrundeliegende Aufgabe besteht darin, ein Herstellverfahren für den erfindungsgemäßen Thyristor anzugeben. Diese Aufgabe wird durch die Merkmale des Patentanspruchs 4 gelöst.

Die Patentansprüche 2 und 3 beziehen sich auf bevorzugte Ausgestaltungen des erfindungsmäßen Thyristors und die Patentansprüche 5 bis 8 betreffen bevorzugte Weiterbildungen des erfindungsgemäßen Herstellverfahrens.

Die Erfindung weist insbesondere den Vorteil auf, daß aufgrund einer vertikal inhomogenen Trägerlebensdauerverteilung der Betriebsstrom im blockierenden Zustand bei Betriebsspannung deutlich geringer ist als bei bekannten Thyristoren, da die durch die Bestrahlung geschädigte Zone bei dieser Spannung außerhalb dieser Raumladungszone liegt und somit nicht zum Generationsstrom beiträgt.

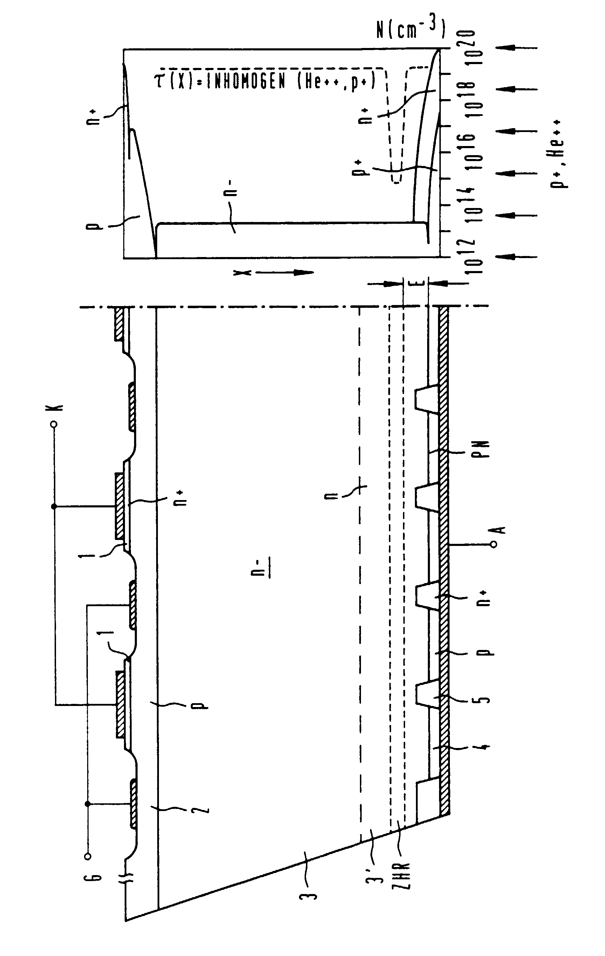

Im folgenden wird die Erfindung anhand der Zeichnung näher erläutert. Ein erster Teil der Zeichnung zeigt eine Schnittdarstellung des erfindungsgemäßen Thyristors, insbesondere eines GTO's, mit einem n-Emitter 1, der in der Regel aus vielen Einzelsegmenten besteht und mit einem Kathodenanschluß K verbunden ist, mit einer p-Basis 2, die mit einem Gateanschluß G verbunden ist, mit einer n-Basis 3, 3' und einem p-Emitter 4, der mit einem Anodenanschluß A verbunden ist. Der n-Emitter 1, die p-Basis 2, die n-Basis 3, 3' und der p-Emitter 4 sind in der angegebenen Reihenfolge angeordnet, wobei zwischen der n-Basis 3, 3' und dem p-Emitter 4 ein anodenseitiger pn-Übergang PN gebildet wird. In einer Entfernung E von 0 bis 40 µm befindet sich in der n-Basis 3, 3' eine Zone ZHR mit hoher Rekombinationsrate, das heißt eine Zone mit geringer Ladungsträgerlebensdauer. Die Zone ZHR erstreckt sich über die Gesamtfläche des erfindungsgemäßen Thyristors und weist eine Dicke im Bereich von 10 bis 20 µm auf.

In der Zeichnung sind darüber hinaus Emitterkurzschlüsse 5 eingezeichnet, die den Anodenanschluß A über n⁺-dotierte Gebiete mit der n-Basis 3, 3' verbinden und bei abschaltbaren Thyristoren üblich jedoch für die Erfindung unerheblich sind. Ferner ist in der Zeichnung durch eine gestrichelte Linie angedeutet, daß die n-Basis nicht homogen n⁻-dotiert zu sein braucht, sondern auch derart ausgeführt sein kann, daß die n-Basis am anodenseitigen Ende ganzflächig einen n-dotierten Bereich als Stoppzone für die Raumladungszone aufweist und die übrige n-Basis 3 n⁻-dotiert ist.
In einem zweiten Teil der Zeichnung sind die Dotierungskonzentrationen N in cm⁻³ über die vertikale Koordinate x und gestrichelt die vertikal inhomogene Ladungsträgerlebensdauerverteilung τ(x) die durch eine anodenseitige Bestrahlung mit Protonen p⁺ oder Heliumkernen He⁺⁺ erzeugt wurde dargestellt.

Bei der Herstellung des erfindungsgemäßen Thyristors wird anodenseitig über die gesamte Fläche des Thyristors und ohne Zwischenschaltung von Blenden oder Masken eine Bestrahlung mit Protonen p⁺ oder Heliumkernen He⁺⁺ vorgenommen. Die Tiefe dieser Zone wird durch die Energie der Protonen oder Heliumkerne vorgegeben und die Stärke der Trägerlebensdauerabsenküng in der stark geschädigten Zone durch die Bestrahlungsdosis eingestellt, wobei die Energie der Heliumkerne zwischen 5 und 10 MeV und die Bestrahlungsdosis 4 bis 10 x 10¹⁰ Atome/cm² beträgt.

Nach der Durchführung der Protonen- oder Heliumbestrahlung kann vorteilhafterweise eine Temperung, zum Beispiel 20 Stunden bei 220°C, zur Stabilisierung der Störstellen, die durch die Bestrahlung mit Heliumkernen oder Protonen erzeugt wurden, durchgeführt werden. Durch die Temperung wird eine Veränderung der Ladungsträgerlebensdauer und damit eine Veränderung der elektrischen Daten bei Betriebstemperatur und Spannungsbelastung auf diese Weise vermieden. Die Temperung kann vorteilhafter Weise in einem Temperaturbereich von 200 bis 250°C und einer Dauer von 10 bis 30 Stunden erfolgen.

Eine nachträgliche Feinkorrektur einer derartigen vertikal inhomogenen Trägerlebensdauereinstellung kann zur weiteren Absenkung der Abschaltverlustleistung zusätzlich mittels einer Elektronenbestrahlung, die die Trägerlebensdauer zusätzlich geringfügig und in vertikaler Richtung homogen absenkt,erfolgen, ohne daß die positiven Eigenschaften des verbesserten Einschaltens und der erhöhten Abschaltfähigkeit wesentlich beeinträchtigt werden.

## Patentansprüche

1. Thyristor mit einem n-Emitter (1), der mit einem Kathodenanschluß (K) verbunden ist, einer p-Basis (2), die mit einem Gateanschluß (G) verbunden ist, einer n-Basis (3, 3') und einem p-Emitter (4), der mit einem Anodenanschluß (A) verbunden ist,
bei dem die n-Basis, in der Nähe eines anodenseitigen pn-Überganges (PN) zwischen dem p-Emitter und der n-Basis, eine Zone (ZHR) mit einer gegenüber der übrigen n-Basis verminderten Ladungsträgerlebensdauer aufweist und
bei dem sich diese Zone (ZHR) über die gesamte Fläche des Thyristors erstreckt, wobei die Entfernung (E) zwischen dieser Zone und dem anodenseitigen pn-Übergang (PN) im wesentlichen an jeder Stelle gleich groß ist,
**dadurch gekennzeichnet,**
daß die Zone (ZHR) mit der verminderten Ladungsträgerlebensdauer eine Dicke im Bereich von 10 bis 20 µm aufweist.

2. Thyristor nach Anspruch 1,
**dadurch gekennzeichnet,**
daß die Entfernung (E) zwischen der Zone (ZHR) mit der verminderten Ladungsträgerlebensdauer und dem anodenseitigen pn-übergang zwischen 0 und 40 µm beträgt.

3. Thyristor nach Anspruch 1 oder 2,
**dadurch gekennzeichnet,**
daß die n-Basis (3, 3') zum anodenseitigen pn-Übergang (PN) hin eine n-Stoppzone (3') aufweist, die höher dotiert ist als die übrige n-Basis (3).

4. Verfahren zur Herstellung eines Thyristors nach einem der Ansprüche 1 bis 3,
**dadurch gekennzeichnet,**
daß anodenseitig eine ganzflächige Bestrahlung mit Protonen (p⁺) oder Heliumkernen (He⁺⁺) erfolgt.

5. Verfahren nach Anspruch 4,
**dadurch gekennzeichnet,**
daß eine Bestrahlung mit Heliumkernen erfolgt, die eine Energie zwischen 5 und 10 MeV aufweisen und daß die Bestrahlungsdosis 4 bis 10 x 10¹⁰ Atome/cm² beträgt.

6. Verfahren nach Anspruch 4,
**dadurch gekennzeichnet,**
daß nach der Bestrahlung mit Protonen oder Heliumkernen zur Stabilisierung der erzeugten Störstellen eine Temperung erfolgt.

7. Verfahren nach Anspruch 5,
**dadurch gekennzeichnet,**
daß die Temperung bei einer Temperatur von 200 bis 250°C und einer Dauer von 10 bis 30 Stunden erfolgt.

8. Verfahren nach Anspruch 4 bis 7,
**dadurch gekennzeichnet,**
daß zusätzlich eine im Vergleich zur Bestrahlung mit Protonen oder Heliumkernen relativ schwache und in vertikaler Richtung homogene Absenkung der Ladungsträgerlebensdauer mittels einer kathoden- oder anodenseitigen Elektronenbestrahlung erfolgt.

## Claims

1. Thyristor having an n-type emitter (1) which is connected to a cathode terminal (K), a p-type base (2) which is connected to a gate terminal (G), an n-type base (3, 3') and a p-type emitter (4) which is connected to an anode terminal (A), in which the n-type base has, in the vicinity of a pn junction (PN) on the anode side between the p-type emitter and the n-type base, a region (ZHR) with a reduced charge-carrier lifetime compared with the rest of the n-type base, and in which this region (ZHR) extends over the entire surface of the thyristor, the distance (E) between this region and the pn junction (PN) on the anode side having essentially the same value at each point, characterized in that the region (ZHR) with the reduced charge-carrier lifetime has a thickness in the range from 10 to 20 µm.

2. Thyristor according to Claim 1, characterized in that the distance (E) between the region (ZHR) with the reduced charge-carrier lifetime and the pn junction on the anode side is between 0 and 40 µm.

3. Thyristor according to Claim 1 or 2, characterized in that the n-type base (3,3') has, in the direction of the pn junction (PN) on the anode side, an n-type stop region (3') which is more heavily doped than the rest of the n-type base (3).

4. Process for producing a thyristor according to one of Claims 1 to 3, characterized in that surface-wide bombardment with protons (p⁺) or helium nuclei (He⁺⁺) is carried out on the anode side.

5. Process according to Claim 4, characterized in that bombardment is carried out with helium nuclei which have an energy of between 5 and 10 MeV and in that the bombardment dose is from 4 to 10 x 10¹⁰ atoms/cm².

6. Process according to Claim 4, characterized in that heat treatment is carried out following the bombardment with protons or helium nuclei in order to stabilize the defects which have been produced.

7. Process according to Claim 5, characterized in that the heat treatment is carried out at a temperature of from 200 to 250°C and for a time of from 10 to 30 hours.

8. Process according to Claims 4 to 7, characterized in that, in addition, a reduction in the charge-carrier lifetime is carried out which is relatively weak in comparison to the bombardment with protons or helium nuclei and is uniform in the vertical direction, by means of electron bombardment on the cathode or anode side.

## Revendications

1. Thyristor ayant un émetteur (1) de type n qui est relié à une borne (K) de cathode, une base (2) de type p qui est reliée à une borne (G) de grille, une base (3, 3') de type n et un émetteur (4) de type p qui est relié à une borne (A) d'anode,
dans lequel la base de type n comporte à proximité d'une jonction (PN) de type pn du côté de l'anode entre l'émetteur de type p et la base de type n une zone (ZHR) ayant une durée de vie des porteurs de charge moindre que dans le reste de la base de type n et
dans lequel cette zone (ZHR) s'étend sur toute la surface du thyristor, la distance (E) entre cette zone et la jonction (PN) de type pn du côté de l'anode étant sensiblement la même en tout point,
caractérisé en ce que
la zone (ZHR) ayant une durée de vie moindre des porteurs de charge a une épaisseur de l'ordre de 10 à 20 µm.

2. Thyristor suivant la revendication 1,
caractérisé en ce que
la distance (E) entre la zone (ZHR) ayant la durée de vie moindre des porteurs de charge et la jonction de type pn du côté de l'anode est comprise entre 0 et 40 µm.

3. Thyristor suivant la revendication 1 ou 2,
caractérisé en ce que
la base (3, 3') de type n a du côté de la jonction (PN) de type pn du côté de l'anode une zone (3') d'arrêt de type n qui est plus dopée que le reste de la base (3) de type n.

4. Procédé de fabrication d'un thyristor suivant l'une des revendications 1 à 3,
caractérisé en ce qu'il consiste
à effectuer du côté de l'anode une exposition sur toute la surface à des protons (p⁺) ou à des noyaux d'hélium (He⁺⁺).

5. Procédé suivant la revendication 4,
caractérisé en ce qu'il consiste
à effectuer une exposition à des noyaux d'hélium qui ont une énergie comprise entre 5 et 10 MeV et en ce que la dose d'exposition est comprise entre 4 et 10 x 10¹⁰ atomes/cm².

6. Procédé suivant la revendication 4,
caractérisé en ce qu'il consiste
à effectuer, après l'exposition à des protons ou à des noyaux d'hélium un recuit pour stabiliser les défauts produits.

7. Procédé suivant la revendication 5,
caractérisé en ce qu'il consiste
à effectuer le recuit à une température de 200 à 250°C pendant une durée de 10 à 30 h.

8. Procédé suivant l'une des revendications 4 à 7,
caractérisé en ce qu'il consiste
à produire en plus au moyen d'une exposition à des électrons du côté de la cathode ou du côté de l'anode une diminution de la durée de vie des porteurs de charge homogène dans la direction verticale et relativement faible par rapport à celle qui est obtenue par l'exposition à des protons ou à des noyaux d'hélium.
